# EUROPÄISCHE PATENTSCHRIFT

(11) **EP 0 710 364 B1**
(45) Veröffentlichungstag und Bekanntmachung des Hinweises auf die Patenterteilung: **20.09.2000**
(21) Anmeldenummer: 94920895.3
(22) Anmeldetag: 19.07.1994
(51) Int. Cl.: G01T 7/00, G01T 1/24

(54) **KAPSEL FÜR EINEN IM ULTRAHOCHVAKUUM ARBEITENDEN DETEKTOR**
ENCLOSURE FOR A DETECTOR OPERATING IN AN ULTRA-HIGH VACUUM
CAPSULE POUR DETECTEUR FONCTIONNANT EN ULTRAVIDE

(30) Priorität: 23.07.1993 DE 4324709
(43) Veröffentlichungstag der Anmeldung: 08.05.1996
(73) Patentinhaber: FORSCHUNGSZENTRUM JÜLICH GMBH, 52425 Jülich (DE); UNIVERSITÄT ZU KÖLN, D-50923 Köln (DE); EURISYS MESURES, F-67834 Tanneries Cédex (FR)
(72) Erfinder: BERST, Marc, F-67300 Schiltigheim (FR); EBERTH, Jürgen, D-51107 Köln (DE); JÄGER, Herbert, M., D-52076 Aachen (DE); KÄMMERLING, Hans, D-52249 Eschweiler (DE); LIEDER, Rainer, M., D-52428 Jülich (DE); RENFTLE, Walter, D-52353 Düren (DE)
(86) Internationale Anmeldenummer: DE9400844
(87) Internationale Veröffentlichungsnummer: WO9503555

(56) Entgegenhaltungen:
- US-A- 3 055 101
- NUCLEAR INSTRUMENTS AND METHODS, Bd.69, 1969, AMSTERDAM,NL Seiten 293 - 302 BUKER,H 'ein hochaufflosendes gammaspektrometer mit einem bohrloch-germanium-detector'
- PATENT ABSTRACTS OF JAPAN Bd. 17, Nr. 522 (P-1616) 20 September 1993 & JP,A,05 142 037 (FUJITSU LTD) 08 Juni 1993

## Beschreibung

Die Erfindung bezieht sich auf eine Kapsel für einen im Ultrahochvakuum arbeitenden Detektor, der als Gamma(γ)-Spektrometer geeignet ist, insbesondere für einen Germanium(Ge)-Detektor.

Zur Spektroskopie von γ-Strahlung werden heute in vielen Bereichen der Forschung und der Industrie Detektoren aus hochreinem Germanium (HPGe) eingesetzt. Diese Detektoren zeichnen sich durch sehr gute Energieauflösung und große Nachweiswahrscheinlichkeit aus - Eigenschaften, die eine universelle Verwendung in der kernphysikalischen Grundlagenforschung und der Weltraumforschung, aber auch bei der Umweltüberwachung, im Strahlenschutz, bei der zerstörungsfreien Materialanalyse und in der industriellen Fertigungskontrolle ermöglichen.

Zur Messung müssen Ge-Detektoren mit flüssigem Stickstoff auf ca. -190°C abgekühlt werden. Dazu werden die Detektoren in einen Vakuumkryostaten eingebaut, der gleichzeitig die sehr empfindliche Oberfläche der Detektoren schützt. Die derzeitige Kryostatentechnologie erschwert die Handhabung und die Wartung der Detektoren und behindert den Einsatz derselben Detektoren bei sehr verschiedenen Meßaufgaben.

In Kapseln als γ-Spektrometer eingesetzte Detektoren werden beispielsweise zur Detektion von in Schwerionenreaktionen erzeugten schnellfliegenden Atomkernen verwendet. Um dabei bei auftretenden Dopplereffekten eine energetische Verbreitung der γ-Linien in Grenzen zu halten, wird angestrebt, den Raumwinkel für die Detektoren möglichst klein zu wählen, die Detektoren sollen eine hohe Granularität aufweisen. Bei der Wechselwirkung zwischen γ-Strahlen und Detektormaterie treten neben dem zu detektierenden Photoeffekt auch Streueffekte auf, insbesondere die sogenannte Comptonstreuung, die einen kontinuierlichen Strahlungsuntergrund ergeben und das Auflösungsvermögen des Detektors beeinträchtigen. Zur Minimalisierung dieses Compton-Untergrundes wird es angestrebt, den Detektor möglichst großvolumig auszubilden. Es wird darüber hinaus ein Anti-Compton-Detektor eingesetzt, mit dem die aus dem Detektor durch Streuung austretende γ-Strahlung ermittelt und unterdrückt werden kann.

Durch Einsetzen der Detektoren in evakuierten Kapseln läßt sich eine hohe Zuverlässigkeit für die mit den Detektoren ermittelten Meßergebnisse erreichen. Die hochempfindlichen Oberflächen der Detektorkristalle werden im ultrahochvakuumdichten Raum geschützt. So ergibt sich eine leichte Handhabbarkeit der Detektoren, insbesondere bei einer notwendigen Regeneration nach Strahlenschäden. Gekapselte Detektoren lassen sich vorteilhaft auch zu Clustern anordnen, die mehrere Detektoren umfassen und so durch Addition der in den einzelnen Detektoren abgegebenen Energien die Gesamtenergie eines γ-Quants mit hoher Genauigkeit trotz Comptonstreuung bestimmen lassen.

Um die Meßempfindlichkeit der Detektorkristalle über lange Betriebszeiten hinweg unverändert zu halten, ist dafür Sorge zu tragen, daß das Hochvakuum im Detektorraum möglichst konstant bleibt.

Aufgabe der Erfindung ist es somit, einen Detektorraum mit einem über lange Betriebszeiten hinweg zuverlässigen Hochvakuum zu schaffen.

Diese Aufgabe wird bei einer Kapsel der eingangs genannten Art durch die im Patentanspurch 1 angegebenen Merkmale gelöst. Zur Aufrechterhaltung des Hochvakuums wird ein Getterelement eingesetzt. Vom Getter werden restliche Gasmoleküle, insbesondere H₂ gebunden. Falls sich die Aufnahmefähigkeit des Getters erschöpft, läßt sich das Getter durch Ausheizen regenerieren. Um hierbei eine Schädigung des Detektors zu vermeiden, ist das Getterelement in einem Getterraum angeordnet, der vom Detektor durch einen thermischen Schutz getrennt ist. Nach Patentanspruch 2 dient als thermischer Schutz eine den Detektor abschirmende Getterbüchse, innerhalb der das Getterelement befestigt ist.

Bevorzugt wird das Getterelement von einem Kapseldeckel gehalten, der geeignet ist, mit einer den Detektorraum umgebenden Kapselhülse durch Elektronenstrahlschweißen vakuumdicht verbunden zu werden, um somit den Detektorraum entsprechend verschließen zu können, Patentanspruch 3. Vorteilhaft ist es, zum Evakuieren von Detektorraum und Getterraum einen Rohranschluß vorzusehen, der sich nach Erreichen des gewünschten Hochvakuums durch Kaltverschweißen, insbesondere durch Verformen durch Quetschen (pinch-off-Technik) vakuumdicht verschließen läßt, Patentanspruch 4. Dies ist insbesondere wegen der für die γ-Spektroskopie mit Ge-Detektoren erforderlichen Verwendung von Aluminium für alle Kapselteile von Bedeutung.

Die Erfindung und weitere Ausgestaltungen der Erfindung werden im folgenden anhand eines Ausführungsbeispiels näher erläutert. Die Zeichnung zeigt im einzelnen:

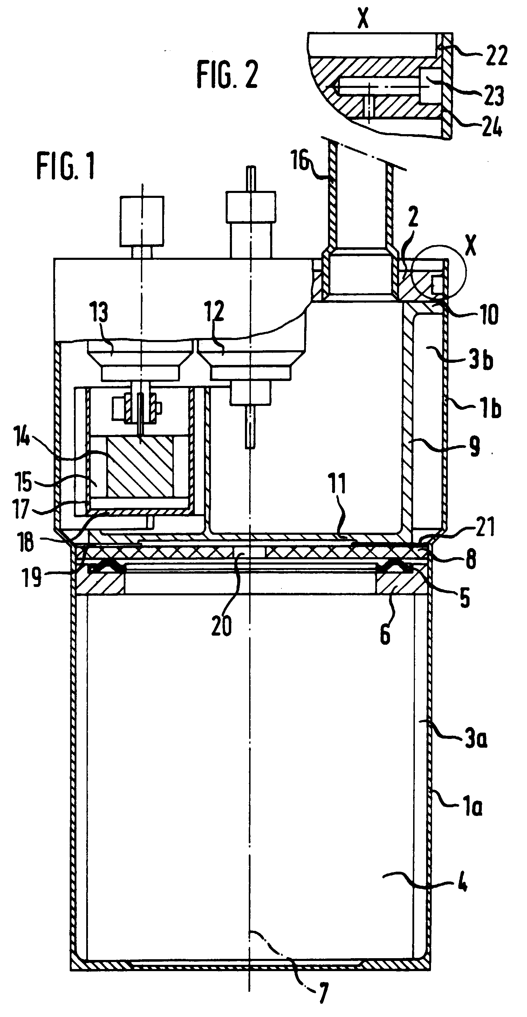

- Fig. 1: Längsschnitt durch eine Kapsel mit Detektor;
- Fig. 2: Einzelheit X einer Kapsel nach Fig. 1.

In der Zeichnung ist eine Kapsel aus einer Aluminiumlegierung mit Kapselhülse 1 (Kapselteile 1a, 1b) und Kapseldeckel 2 dargestellt. Die Kapselhülse 1 umschließt einen Detektorraum 3, der zwei Detektorraumbereiche 3a, 3b aufweist. Im Bereich 3a im unteren Teil 1a der Kapselhülse 1 ist als γ-Spektrometer ein Detektor 4, im Ausführungsbeispiel ein Detektorkristall aus Germanium (Ge) eingesetzt. Als Detektormaterial für die γ-Spektroskopie eignet sich neben Ge auch Silicium (Si). Aus beiden Materialien lassen sich Detektoren mit hoher Energieauflösung fertigen.

Der Detektor 4 ist im Detektorraumbereich 3a mittels einer Tellerfeder 5 kraftschlüssig verspannt. Die Tellerfeder 5 wird in einer Ausnehmung eines Zentrierringes 6 zentrisch zur Achse 7 der Kapselhülse 1 geführt, der Zentrierring 6 liegt stirnseitig auf dem Detektor 4 auf.

Die Tellerfeder 5 stützt sich über eine Keramikscheibe 8 und einen Druckring 9 gegen den Kapseldeckel 2 ab. Der Druckring 9 weist hierzu eine Stützfläche 10 auf, deren Rand so bemessen ist, daß der Druckring 9 beim Einsetzen in die Kapselhülse 1 zugleich zentriert wird. Die Zylinderlänge des Druckrings 9 bestimmt im Detektorraumbereich 3b zwischen Kapseldeckel 2 und Druckringboden 11 einen Zwischenraum, der beim Elektronenstrahlverschweißen zwischen Kapselhülse und Kapseldeckel als thermischer Schutz für den im unteren Teil 1a der Kapselhülse untergebrachten Detektor 4 wirkt.

In der Zeichnung sind im Kapseldeckel 2 schematisch Durchführungen 12, 13 für die Meß- und Stromleitungen wiedergegeben. Eine der Durchführungen, im Ausführungsbeispiel die Durchführung 13 dient als Stromdurchführung für ein Getterelement 14, über das während des Detektorbetriebes das erforderliche Hochvakuum im Detektorraum durch Bindung von Gasresten, insbesondere H₂, im Gettermaterial aufrechterhalten wird.

Im Ausführungsbeispiel ist im Getterraum 15 ein poröser Getter eingesetzt, der unter der Firmenbezeichnung St 172 SAES-Getter erhältlich ist und die Gasreste durch Chemiesorption oder chemische Reaktion mit dem Getterwerkstoff löst. Durch die Getterung läßt sich das erforderliche Hochvakuum über lange Betriebszeiten hinweg aufrechterhalten. Eine Aktivierung des Gettermaterials wird durch Ausheizen erreicht.

Zum Evakuieren von Detektorraum 3a, 3b und Getterraum 15 ist im Kapseldeckel 2 ein Rohranschluß 16 eingesetzt. Der Rohranschluß besteht in gleicher Weise wie alle Kapselteile aus Aluminium und wird nach Abpumpen von Detektorraum und Getterraum und nach Erreichen des erforderlichen Hochvakuums im Kapselinnenraum durch Abquetschen vakuumdicht kaltverschweißt (pinch-off-Technik).

Zum Aktivieren des Getters wird wie folgt vorgegangen:

Über den Rohranschluß 16 wird die Kapsel an einen Ultrahochvakuum-Pumpstand angeschlossen. Dann wird die Kapsel ausgeheizt, und es wird im Detektor- und Getterraum Ultrahochvakuum erzeugt. Die Aktivierung des Getters erfolgt durch elektrisches Aufheizen des Gettermaterials auf 900°C, die Temperatur wird ca. 10 Min lang gehalten. Nach der Getteraktivierung wird der evakuierte Raum versiegelt. Dies geschieht durch Verschließen des Rohranschlusses 16 durch Kaltverschweißen (Pinch-off-Technik).

Eine Reaktivierung des Getters wird durchgeführt, wenn eine Regeneration des Gettermaterials bei nachlassender Getterwirkung erforderlich ist. Ein Ausbau des Getterelements aus der Kapsel ist hierzu nicht erforderlich.

Während der Aktivierungsmaßnahmen bleibt der temperaturempfindliche Detektor 4 im Detektorraumbereich 3b vor schädlicher Wärmeeinwirkung geschützt. Das elektrisch aufheizbare Getterelement 14 ist in einer Getterbüchse 17 eingesetzt, die an einer ihrer Stirnseiten geöffnet ist. Die Getterbüchse 17 ist am Kapseldeckel 2 so befestigt, daß ihr geschlossener stirnseitiger Boden 18 zum Detektor 4 hinweist. Die Getterbüchse 17 umgibt auf diese Weise das Getterelement 14 als thermischer Schutz für den Detektor. Der Detektor wird insbesondere vor thermischer Strahlung geschützt, der Boden 18 der Getterbüchse 17 ist deshalb zur Abschirmung gegenüber dem Detektor 4 optisch dicht gestaltet. Wesentlich für den thermischen Schutz des Detektormaterials vor einer unerwünschten Überhitzung ist auch eine Unterbringung des Detektors 4 im unteren Bereich 3a des Detektorraums, während die Getterbüchse 17 durch ihre Befestigung am Kapseldeckel 2 im oberen Bereich 3b des Detektorraums angeordnet ist. Neben der Getterbüchse 17 wirkt als thermischer Schutz insbesondere die Keramikscheibe 8, die zwischen oberem und unteren Detektorraumbereich 3a, 3b eingesetzt ist.

Räumlich sind der untere und obere Bereich 3a, 3b des Detektorraums 3 über Durchbrüche 19, 20 in Druckringboden 11 und Keramikscheibe 8 miteinander verbunden. Die Durchbrüche 19 im Druckringboden 11 befinden sich zwischen Stegen 21, mit denen der Druckringboden 11 auf der Keramikscheibe 8 aufsitzt.

Der den Detektorraum verschließende Kapseldeckel 2 ist am oberen Teil 1b am äußeren Rand 22 der Kapselhülse elektronenstrahlverschweißt. Damit beim Elektronenstrahlschweißen entstehende Schweißdämpfe, die gegebenenfalls in den Detektorraum 3 eindringen könnten, noch vor Erreichen des Detektorraums zurückgehalten werden, weist der Kapseldeckel eine als Ringnut ausgebildete Kammer 23 auf, in der sich die Schweißdämpfe niederschlagen können, siehe Fig. 2, Einzelheit X. Die Kapselhülse kann erforderlichenfalls beim Elektronenstrahlschweißen gekühlt werden.

Zum Elektronenstrahlschweißen wird der Kapseldeckel 2 - zusammen mit der am Kapseldeckel befestigten Getterbüchse 17 mit Getterelement 14 - gegen den Druck der Tellerfeder 5 mittels Preßsitz kraftschlüssig in der Kapselhülse 1 verspannt. Hierzu weist der Kapseldeckel einen konisch geformten Außenrand 24 auf, mit dem der Kapseldeckel 2 in die Kapselhülse 1 gedrückt wird. Diese Ausbildung des Kapseldeckels wirkt beim Elektronenstrahlschweißen zugleich als Dampfsperre.

## Patentansprüche

1. Kapsel für einen im Ultrahochvakuum (UHV) arbeitenden Detektor, der als Gamma(γ)-Spektrometer geeignet ist, insbesondere für einen Germanium(Ge)-Detektor,
**dadurch gekennzeichnet**,
daß zur Aufrechterhaltung des Hochvakuums ein durch Aufheizen aktivierbares Getterelement (14) in einem vom Detektor (4) durch einen thermischen Schutz getrennten Getterraum (15) angeordnet ist.

2. Kapsel nach Anspruch 1,
**dadurch gekennzeichnet**,
daß das Getterelement (14) zum thermischen Schutz in einer den Detektor (4) abschirmenden Getterbüchse (17) eingesetzt ist.

3. Kapsel nach Anspruch 1 oder 2,
**dadurch gekennzeichnet**,
daß das Getterelement (14) vom Kapseldeckel (2) gehalten ist, der mit einer den Detektorraum (3a, 3b) mugebenden Kapselhülse (1) durch Elektronenstrahlschweißen vakuumdicht verbunden ist.

4. Kapsel nach einem der vorhergehenden Ansprüche 1 bis 3,
**dadurch gekennzeichnet**,
daß Detektorraum (3a, 3b) und Getterraum (15) über einen Rohranschluß (16) evakuierbar sind, der nach Erreichen des gewünschten Hochvakuums durch Kaltverschweißen vakuumdicht verschließbar ist.

## Claims

1. Capsule for a detector operating in an ultra-high vacuum (UHV) and suitable as a gamma-ray (γ) spectrometer, more particularly a capsule for a germanium (Ge) detector,
characterised in that to maintain the high vacuum a getter (14) adapted to be activated by being heated is arranged in a getter compartment (15) separated from the detector (4) by a heat guard.

2. Capsule according to claim 1,
characterised in that the getter (14) constituting the heat guard is inserted in a getter sleeve (17) which shields the detector (4).

3. Capsule according to claim 1 or 2,
characterised in that the getter (14) is held by the capsule lid (2) which is joined in a vacuum-tight manner by electron-beam welding it to a capsule sleeve (1) surrounding the detector compartment (3a, 3b).

4. Capsule according to any of preceding claims 1 to 3,
characterised in that the detector compartment (3a, 3b) and the getter compartment (15) are adapted to be evacuated via a tube connector (16) which can be sealed in a vacuum-tight manner by cold-welding it once the desired high vacuum has been obtained.

## Revendications

1. Capsule pour un détecteur fonctionnant sous vide ultrapoussé (VUP), qui convient comme spectromètre gamma (γ) notamment pour un détecteur au germanium (Ge),
caractérisée en ce que pour maintenir le vide ultrapoussé, un élément (14) sorbant qui peut être activé par chauffage est placé dans une chambre (15) pour sorbant, qui est séparée du détecteur (4) par une protection thermique.

2. Capsule suivant la revendication 1,
caractérisée en ce que l'élément (14) sorbant est inséré pour la protection thermique dans une douille (17) de sorbant, protégeant le détecteur (4).

3. Capsule suivant la revendication 1 ou 2,
caractérisée en ce que l'élément (14) sorbant est maintenu par le couvercle (2) de la capsule qui est relié, d'une manière étanche au gaz par soudage par un faisceau d'électrons, à une douille (1) de capsule entourant la chambre (3a, 3b) du détecteur.

4. Capsule suivant l'une des revendications précédentes 1 à 3,
caractérisée en ce que la chambre (3a, 3b) du détecteur et la chambre (15) du sortant peuvent être mises sous vide par un raccord (16) tubulaire, qui peut être fermé d'une manière étanche au vide par soudage à froid, après que le vide ultrapoussé souhaité a été atteint.
